# EUROPEAN PATENT SPECIFICATION

(11) **EP 3 624 100 B1**
(45) Date of publication and mention of the grant of the patent: **02.06.2021**
(21) Application number: 18901277.6
(22) Date of filing: 26.09.2018
(51) Int. Cl.: G09G 3/32, G09G 3/3266, G11C 19/28

(54) **LIGHT EMITTING CONTROL CIRCUIT, LIGHT EMITTING CONTROL DRIVER AND DISPLAY DEVICE**
LICHTEMITTIERENDE STEUERSCHALTUNG, LICHTEMITTIERENDER STEUERTREIBER UND ANZEIGEVORRICHTUNG
CIRCUIT DE COMMANDE D'ÉMISSION DE LUMIÈRE, PILOTE DE COMMANDE D'ÉMISSION DE LUMIÈRE ET DISPOSITIF D'AFFICHAGE

(30) Priority: 19.01.2018 CN 201820093773 U
(43) Date of publication of application: 18.03.2020
(73) Proprietor: KUNSHAN GO-VISIONOX OPTO-ELECTRONICS CO., LTD., Kunshan, Jiangsu 215300 (CN)
(72) Inventor: WU, Jianlong, Kunshan, Jiangsu 215300 (CN); HU, Siming, Kunshan, Jiangsu 215300 (CN); ZHU, Hui, Kunshan, Jiangsu 215300 (CN)
(74) Representative: D'Halleweyn, Nele Veerle Trees Gertrudis
(86) International application number: PCT/CN2018/107595
(87) International publication number: WO 2019/140946

(56) References cited:
- CN-A- 101 256 735
- CN-A- 102 708 795
- CN-A- 104 751 770
- CN-U- 207 781 162
- US-A1- 2014 055 444
- US-A1- 2017 301 295
- US-B2- 9 262 962

## Description

### TECHNICAL FIELD

Embodiments of the present application relate to the field of display technologies, and more specifically to an emission control circuit, an emission control driver and a display device.

### BACKGROUND

Generally, a display device may include a plurality of pixels, a data driver, a scan driver, and an emission control driver. The plurality of pixels are configured to display an image, the data driver is configured to provide data voltages to the pixels, the scan driver is configured to provide scanning signals to the pixels, the emission control driver is configured to provide emission control signals to the pixels, and the emission control signals may control emission time of the pixels.

As for an emission control driver, the emission control driver may include multiple-stages of emission control circuits, each of which may be configured to control emission time of a row of the pixels. As for one stage of emission control circuit, which may include a plurality of thin film transistors, an initial signal, and a plurality of clock signals, may control the thin film transistors to be in on-state or off-state, so that the emission control circuit can output the emission control signals.

In the prior art however, each stage of the emission control circuit includes a large number of thin film transistors (usually more than 20), resulting in a complicated emission control circuit.

US 2014/0055444 A1 provides an emission control driver which includes stages sequentially out-putting emission control signals through emission controllines. Each stage incledes a first signal processor, a second signal processor and a third signal processor. And the third signal processor includes eighth, ninth, and tenth transistors M8, M9, and M10 and a third capacitor C3. US 2017/0301295 A1 provides an emission control driver which includes a plurality of stages configured to output a plurality of emission control signals, respectively. Each stage includes a plurality of transistors and capacitors.

### SUMMARY

In response to the above problems, an emission control circuit is provided in embodiments of the present application, and the circuit includes less thin film transistors and has a simple structure, to achieve requirements of simplifying a structure of the emitting control circuit.

The invention is set out in the appended set of claims 1-9.

The emission control signal output by the emission control circuit according to the embodiments of the present application may control pixels to emit light, and the circuit structure of the emission control circuit is relatively simple compared to the prior art.

### BRIEF DESCRIPTION OF DRAWINGS

FIG. 1 is a schematic structural diagram of an emission control circuit according to an embodiment of the present application.
FIG. 2 is a schematic structural diagram of another emission control circuit according to another embodiment of the present application.
FIG. 3 is a timing diagram of a method for controlling emission according to an embodiment of the present application.
FIG. 4 is a schematic structural diagram of an emission control driver according to an embodiment of the present application.
FIG. 5 is a timing diagram of an emission control driver according to an embodiment of the present application.

### DETAILED DESCRIPTION

In order to make the purposes, technical means and advantages of the present application clear, the present application will be further described in detail below with reference to the accompanying drawings. Obviously, the described embodiments are only a part of the embodiments of the present application, and not all of the embodiments of the present application. Based on the embodiments in the present application, all other embodiments, obtained by those skilled in the art without creative efforts, are within the scope of the present application.

In the embodiments of the present application, a first thin film transistor, a second thin film transistor, a third thin film transistor, a fourth thin film transistor, a fifth thin film transistor, a sixth thin film transistor, a seventh thin film transistor, an eighth thin film transistor, a ninth thin film transistor, and a tenth thin film transistor may all be N-type thin film transistors, or may all be P-type thin film transistors. Alternatively, at least one of the transistors may be a N-type thin film transistor, and the rest of the transistors are P-type thin film transistors, which is not specifically limited herein.

The technical solutions provided by the embodiments of the present application are described in detail below with reference to the accompanying drawings.

### First Embodiment

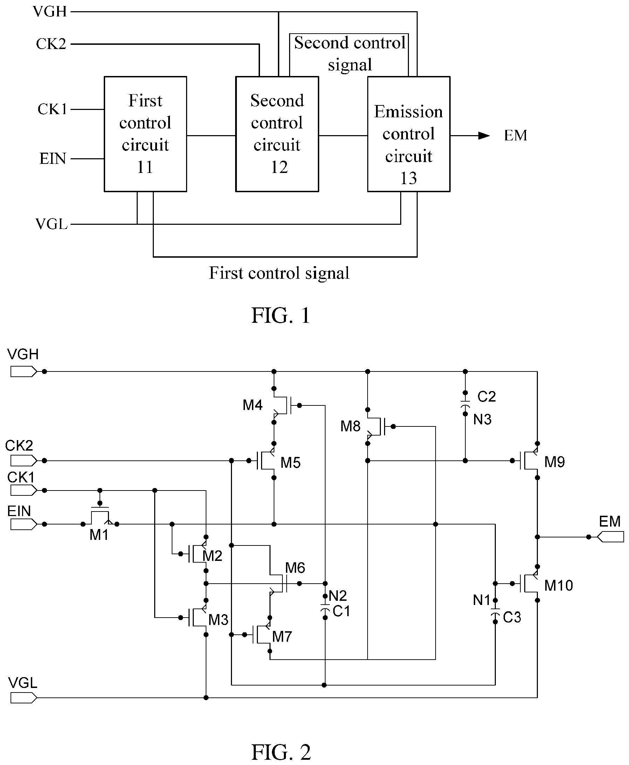

FIG. 1 is a schematic structural diagram of an emission control circuit according to an embodiment of the present application. The emission control circuit can generate an emission control signal that can control emission time of pixels. The emission control circuit is described below.

As shown in FIG. 1, the emission control circuit provided by the embodiments of the present application may include: a first control unit 11, a second control unit 12, and an emission control unit 13.

An input terminal of the first control unit 11 may be respectively connected to an initial signal line, a first clock signal line, and a first power source VGL. The initial signal line may provide an initial signal EIN, the first clock signal line may provide a first clock signal CK1. The first clock signal CK1 may be a pulse signal, and the first power source VGL may have a negative voltage, i.e. the first power source VGL may output a low level. The first control unit 11 may be configured to output a first control signal under control of the initial signal EIN, the first clock signal CK1, and the first power source VGL.

An input terminal of the second control unit 12 may be respectively connected to the first control unit 11, a second clock signal line, and a second power source VGH. The second clock signal line may provide a second clock signal CK2, and the second clock signal CK2 may also be a pulse signal. The second power source VGH may have a positive voltage, i.e. the second power source VGH may output a high level. The second control unit 12 may be configured to output a second control signal under control of the first control unit 11, the second clock signal CK2, and the second power source VGH.

An input terminal of the emission control unit 13 may be respectively connected to the first control unit 11, the second control unit 12, the first power source VGL and the second power source VGH. The first control signal and the second control signal may be input to the emission control unit 13, and the emission control unit 13 may be configured to output an emission control signal EM under control of the first control signal and the second control signal.

A circuit structure of the emission control circuit provided by the embodiments of the present application is relatively simple. The emission control unit may output the emission control signal under control of the first control unit, the second control unit, the clock signal, and the voltage of the power source; and the emission control signal may control the emission time of the pixels.

In an embodiment of the present application, the emission control unit 13 may include: a ninth thin film transistor M9, a tenth thin film transistor M10, a second capacitor C2, and a third capacitor C3. A source of the ninth thin film transistor M9 is connected to the second power source VGH, a drain of the ninth thin film transistor M9 is connected to a source of the tenth thin film transistor M10, and a gate of the ninth thin film transistor M9 is connected to the output terminal, configured to output the second control signal, of the second control unit 12.

A drain of the tenth thin film transistor M10 is connected to the first power source VGL, and a gate of the tenth thin film transistor M10 is connected to the output terminal, configured to output the first control signal, of the first control unit 11.

A terminal of the second capacitor C2 is connected to the output terminal, configured to output the second control signal, of the second control unit 12, and another terminal of the second capacitor C2 is connected to the second power source VGH.

A terminal of the third capacitor C3 is connected to the second clock signal CK2, and another terminal of the third capacitor C3 is connected to the output terminal, configured to output the first control signal, of the first control unit 11.

The drain of the ninth thin film transistor M9 or the source of the tenth thin film transistor M10 is the output terminal of the emission control unit 13, and a signal output by the drain of the ninth thin film transistor M9 or the source of the tenth thin film transistor M10 is the emission control signal.

In another embodiment provided by the present application, the first control unit 11 shown in FIG. 1 may include: a first thin film transistor, a second thin film transistor, and a third thin film transistor.

In another embodiment provided by the present application, the second control unit 12 shown in FIG. 1 may include: a fourth thin film transistor, a fifth thin film transistor, a sixth thin film transistor, a seventh thin film transistor, an eighth thin film transistor, and a capacitor.

Referring to FIG. 2, FIG. 2 is a schematic structural diagram of an emission control circuit according to another embodiment of the present application. The first control unit 11 includes a first thin film transistor M1, a second thin film transistor M2, and a third thin film transistor M3.The second control unit 12 includes a fourth thin film transistor M4, a fifth thin film transistor M5, a sixth thin film transistor M6, a seventh thin film transistor M7, an eighth thin film transistor M8, and a first capacitor CI.The emission control unit 13 includes a ninth thin film transistor M9, a tenth thin film transistor M10, a second capacitor C2, and a third capacitor C3. The thin film transistors, shown in FIG. 2, are all P-type thin film transistors. The circuit structure of the emission control circuit shown in FIG. 2 is as follows.

A gate of the first thin film transistor M1 is respectively connected to a source of the second thin film transistor M2, a gate of the third thin film transistor M3, and the first clock signal line; a drain of the first thin film transistor M1 is connected to the initial signal line; and a source of the first thin film transistor M1 is respectively connected to a gate of the second thin film transistor M2, a drain of the fifth thin film transistor M5, a gate of the eighth thin film transistor M8, a gate of the tenth thin film transistor M10, and one terminal of the third capacitor C3 (a first node N1 shown in FIG. 2).

A drain of the second thin film transistor M2 is connected to a source of the third thin film transistor M3.

A drain of the third thin film transistor M3 is connected to the first power source VGL.

A gate of the fourth thin film transistor M4 is respectively connected to a gate of the sixth thin film transistor M6 and one terminal of the first capacitor C1 (a second node N2 shown in FIG. 2), and a source of the fourth thin film transistor M4 is connected to a source of the fifth thin film M5, and a drain of the fourth thin film transistor M4 is respectively connected to a drain of the eighth thin film transistor M8 and the second power source VGH.

A gate of the fifth thin film transistor M5 is respectively connected to the second clock signal line, a drain of the sixth thin film transistor M6, a gate of the seventh thin film transistor M7, another terminal of the first capacitor C1, and another terminal of the third capacitor C3.

A source of the sixth thin film transistor M6 is connected to a source of the seventh thin film transistor M7.

A drain of the seventh thin film transistor M7 is respectively connected to a source of the eighth thin film transistor M8, a gate of the ninth thin film transistor M9, and a terminal of the second capacitor C2 (a third node N3 shown in FIG. 2).

A source of the ninth thin film transistor M9 is respectively connected to the second power source VGH and another terminal of the second capacitor C2, and a drain of the ninth thin film transistor M9 is connected to a source of the tenth thin film transistor M10.

A drain of the tenth thin film transistor M10 is connected to the first power source VGL.

In the emission control circuit shown in FIG. 2, a signal output by the source of the first thin film transistor M1 (i.e., the first node N1 shown in FIG. 2) may be regarded as the first control signal; a signal output by the source of the eighth thin film transistor M8 (i.e., the third node N3 shown in FIG. 2) may be regarded as the second control signal; a signal output by the drain of the ninth thin film transistor M9 (or the source of the tenth thin film transistor M10) may be regarded as the emission control signal EM.

The first control signal may be output to the gate of the tenth thin film transistor M10 and the tenth thin film transistor M10 is controlled by the first control signal to be in on-state or off-state; the second control signal may be output to the gate of the ninth thin film transistor M9 and the ninth thin film transistor M9 is controlled by the second control signal to be in on-state or off-state. The emission control signal EM may be output to pixels and the emission control signal EM is configured to control emission time of the pixels.

It should be understood that a type of the first thin film transistor M1, the second thin film transistor M2, the third thin film transistor M3, the fourth thin film transistor M4, the fifth thin film transistor M5, the sixth thin film transistor M6, the seventh thin film transistor M7, the eighth thin film transistor M8, the ninth thin film transistor M9 and the tenth thin film transistor M10, may be selected according to a practical application. For example, the first thin film transistor M1, the second thin film transistor M2, the third thin film transistor M3, the fourth thin film transistor M4, the fifth thin film transistor M5, the sixth thin film transistor M6, the seventh thin film transistor M7, the eighth thin film transistor M8, the ninth thin film transistor M9 and the tenth thin film transistor M10 may all be the P-type thin film transistor as described above; or at least one thin film transistor of the first thin film transistor M1, the second thin film transistor M2, the third thin film transistor M3, the fourth thin film transistor M4, the fifth thin film transistor M5, the sixth thin film transistor M6, the seventh thin film transistor M7, the eighth thin film transistor M8, the ninth thin film transistor M9 and the tenth thin film transistor M10 is an N-type thin film transistor.

In an embodiment of the present application, the first capacitor C1 and the third capacitor C3 may be bootstrap capacitors configured to raise or lower a level of a node, and the second capacitor C2 may be a storage capacitor configured to maintain the level of the node. This embodiment is described more specifically below.

One terminal of the first capacitor C1 (i.e., the second node N2 shown in FIG. 2) is respectively connected to the gate of the fourth thin film transistor M4 and the gate of the sixth thin film transistor M6, and another terminal of the first capacitor C1 is connected to the second clock signal line. When a level of the second clock signal CK2 changes, the first capacitor C1 may be configured to raise or lower a level of the second node N2, and thereby the fourth thin film transistor M4 and the sixth thin film transistor M6 are controlled to be in on-state or off-state.

One terminal of the second capacitor C2 (i.e., the third node N3 shown in FIG. 2) is respectively connected to the source of the eighth thin film transistor M8 and the gate of the ninth thin film transistor M9, and another terminal of the second capacitor C2 is connected to the second power source VGH. When the eighth thin film transistor M8 is in on-state, a voltage of the third node N3 is a high level, and when the eighth thin film transistor M8 is turned from being in on-state to being in off-state, since the second capacitor C2 is the storage capacitor, the second capacitor C2 may be configured to keep the high level of the third node N3 unchanged, and thereby the ninth thin film transistor M9 is controlled to remain being in off-state.

One terminal of the third capacitor C3 (i.e., the first node N1 shown in FIG. 2) is respectively connected to the gate of the second thin film transistor M2, the gate of the eighth thin film transistor M8, and the gate of the tenth thin film transistor M10, and another terminal of the third capacitor C3 is connected to the second clock signal line. When the voltage output by the second clock signal CK2 changes, the third capacitor C3 may be configured to raise or pull down a voltage of the first node N1, and thereby the second thin film transistor M2, the eighth thin film transistor M8 and the tenth thin film transistor M10 are controlled to be in on-state or off-state.

It should be noted that, since another terminal of the first capacitor C1 is directly connected to the second clock signal line in the embodiment of the present application, a delay of the second clock signal CK2 to the first capacitor C1 can be reduced, and charging time of the second clock signal CK2 to the first capacitor C1 can be shortened, and thereby the control efficiency of the first capacitor C1 to the fourth thin film transistor M4 and the sixth thin film transistor M6 can be increased, so that the emission control circuit may work at a higher frequency and a higher frequency emission control signal EM is output. Similarly, for the third capacitor C3, another terminal of the third capacitor C3 is directly connected to the second clock signal line, and a delay of the second clock signal CK2 to the third capacitor C3 can be reduced, and the control efficiency of the third capacitor C3 to the second thin film transistor M2, the eighth thin film transistor M8, and the tenth thin film transistor M10 may be increased, so that a higher frequency emission control signal EM is output.

In an embodiment of the present application, in order to ensure that the emission control circuit can output the emission control signal EM normally, when the tenth thin film transistor M10 is controlled by the first control signal to be in on-state, the ninth thin film transistor M9 may be controlled by the second control signal to be in off-state; or, when the tenth thin film transistor M10 is controlled by the first control signal to be in off-state, the ninth thin film transistor M9 may be controlled by the second control signal to be in on-state.

Specifically, as shown in FIG. 2, when the tenth thin film transistor M10 is controlled by the first control signal to be in on-state, and the ninth thin film transistor M9 is controlled by the second control signal to be in off-state, the first power source VGL may be output to an EM end for the emission control signal through the tenth thin film transistor M10, i.e., the emission control unit outputs the first power source VGL; when the tenth thin film transistor M10 is controlled by the first control signal to be in off-state, and the ninth thin film transistor M9 is controlled by the second control signal to be in on-state, the second power source VGH may be output to an EM end for the emission control signal through the ninth thin film transistor M9, i.e., the emission control unit outputs the second power source VGH.

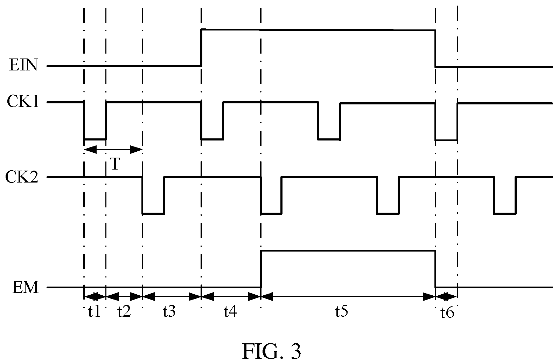

FIG. 3 is a timing diagram of a driving method of the emission control circuit according to an embodiment of the present application. The timing diagram may be a timing diagram corresponding to a first stage of the emission control circuit in an emission control driver, and the timing diagram may be configured to drive the emission control circuit shown in FIG. 2.

In FIG. 3, EIN is an initial signal, CK1 is a first clock signal, CK2 is a second clock signal, and EM is an emission control signal. The first clock signal CK1 and the second clock signal CK2 have the same frequency, and the second clock signal CK2 has a delay time relative to the first clock signal CK1. The specific delay time is a time T, and the time T may be half of a period of the first clock signal CK1. Duration of the high level in the initial signal EIN may be twice the period of the first clock signal CK1.

A duty period of the timing diagram shown in FIG. 3 may be divided into six phases: a first phase t1, a second phase t2, a third phase t3, a fourth phase t4, a fifth phase t5, and a sixth phase t6.

In the first phase t1, the initial signal EIN has a low level, the first clock signal CK1 has a low level, and the second clock signal CK2 has a high level.

Under control of the first clock signal CK1, the first thin film transistor M1 and the third thin film transistor M3 are in on-state, and the initial signal EIN is applied to the first node N1 through the first thin film transistor M1, so that the first node N1 has a low level, and then the second thin film transistor M2, the eighth thin film transistor M8, and the tenth thin film transistor M10 are in on-state. The first clock signal CK1 is applied to the second node N2 through the second thin film transistor M2, and the first power source VGL is applied to the second node N2 through the third thin film transistor M3, so that the second node N2 has a low level, and then the forth thin film transistors M4 and the sixth thin film transistor M6 are in on-state.

Under control of the second clock signal CK2, the fifth thin film transistor M5 and the seventh thin film transistor M7 are in off-state. Since the eighth thin film transistor M8 is in on-state, the second power source VGH is applied to the third node N3 through the eighth thin film transistor M8, so that the third node N3 has a high level, and then the ninth thin film transistor M9 is in off-state.

Thus, in the first phase t1, since the ninth thin film transistor M9 is in off-state and the tenth thin film transistor M10 is in on-state, the first power source VGL may be output by the tenth thin film transistor M10, so that the emission control signal EM has a low level.

In the second phase t2, the initial signal EIN has a low level, the first clock signal CK1 has a high level, and the second clock signal CK2 has a high level.

At this time, due to the first clock signal CK1, the first thin film transistor M1 and the third thin film transistor M3 are in off-state. For the first node N1, since the second clock signal CK2 at another terminal of the third capacitor C3 remains unchanged, the first node N1 will has the low level of the first phase t1, and then the second thin film transistor M2, the eighth thin film transistor M8, and the tenth thin film transistor M10 are still in on-state. The first clock signal CK1 is applied to the second node N2 through the second thin film transistor M2, so that the second node N2 has the high level and the fourth thin film transistor M4 and the sixth thin film transistor M6 are in off-state.

Due to the second clock signal CK2, the fifth thin film transistor M5 and the seventh thin film transistor M7 are still in off-state. Since the eighth thin film transistor M8 is in on-state, the third node N3 has the high level due to the second power source VGH, and then the ninth thin film transistor M9 is still in off-state.

Thus, in the second phase t2, since the ninth thin film transistor M9 is in off-state and the tenth thin film transistor M10 is in on-state, the first power source VGL may be output by the tenth thin film transistor M10, so that the emission control signal EM has a low level.

In the third phase t3, the initial signal EIN has a low level, the first clock signal CK1 has a high level, the second clock signal CK2 has a low level, and then changed from the low level to a high level.

At this time, due to the first clock signal CK1, the first thin film transistor M1 and the third thin film transistor M3 are in off-state. When the second clock signal CK2 has the low level, the fifth thin film transistor M5 and the seventh thin film transistor M7 are in on-state, and because of a bootstrap effect of the third capacitor C3, the voltage of the first node N1 is lowered and the voltage of the first node N1 is lower than the voltage of the first node N1 in the second phase t2, and then the second thin film transistor M2, the eighth thin film transistor M8, and the tenth thin film transistor M10 are in on-state. The first clock signal CK1 is applied to the second node N2 through the second thin film transistor M2, so that the second node N2 still has the high level and then the fourth thin film transistor M4 and the sixth thin film transistor M6 are in off-state. Since the eighth thin film transistor M8 is in on-state, and the voltage of the second power source VGH is applied to the third node N3 through the eighth thin film transistor M8, so that the third node N3 still has the high level, and then the ninth thin film transistor M9 is in off-state.

Thus, since the ninth thin film transistor M9 is in off-state and the tenth thin film transistor M10 is in on-state, the first power source VGL may be output by the tenth thin film transistor M10, so that the emission control signal EM has a low level.

When the second clock signal CK2 is changed from the low level to the high level, the fifth thin film transistor M5 and the seventh thin film transistor M7 are in off-state. At this time, because of the bootstrap effect of the third capacitor C3, the voltage of the first node N1 rises, but the first node N1 still has the low level, and then due to the first node N1, the second thin film transistor M2, the eighth thin film transistor M8, and the tenth thin film transistor M10 are still in on-state. Due to the first clock signal CK1, the first thin film transistor M1 and the third thin film transistor M3 are still in off-state, and the first clock signal CK1 is applied to the second node N2 through the second thin film transistor M2, so that the second node N2 has the high level and then the fourth thin film transistor M4 and the sixth thin film transistor M6 are in off-state. The second power source VGH is applied to the third node N3 through the eighth thin film transistor M8, so that the third node N3 has the high level and then the ninth thin film transistor M9 is still in off-state.

Thus, since the ninth thin film transistor M9 is still in off-state and the tenth thin film transistor M10 is still in on-state, the first power source VGL may be output by the tenth thin film transistor M10, so that the emission control signal EM has a low level.

In summary, in the third phase t3, the emission control signal EM has a low level.

In the fourth phase t4, the initial signal EIN has a high level, the first clock signal CK1 has a low level, and then changes from the low level to the high level, the second clock signal CK2 has a high level.

At this time, when the first clock signal CK1 has the low level, the first thin film transistor M1 and the third thin film transistor M3 are in on-state, and the initial signal EIN is applied to the first node N1 through the first thin film transistor M1, so that the first node N1 has the high level and then the second thin film transistor M2, the eighth thin film transistor M8, and the tenth thin film transistor M10 are in off-state. The first power source VGL is applied to the second node N2 through the third thin film transistor M3, so that the second node N2 has the low level, the fourth thin film transistor M4 and the sixth thin film transistor M6 are in on-state.

Due to the second clock signal CK2, the fifth thin film transistor M5 and the seventh thin film transistor M7 are in off-state. Since the eighth thin film transistor M8 is in off-state, under a storage control of the second capacitor C2, the third node N3 still has the high level being same as the high level in the third phase t3, and the ninth thin film transistor M9 turns to be in off-state.

Thus, since the ninth thin film transistor M9 and the tenth thin film transistor M10 are both in off-state, the emission control signal EM still has the low level being same as the low level in the third phase t3.

When the first clock signal CK1 has the high level, the first thin film transistor M1 and the third thin film transistor M3 are in off-state, the first node N1 will still has the high level, and the second node N2 will keep the low level unchanged, the third node N3 will keep the high level unchanged. At this time, the second thin film transistor M2, the eighth thin film transistor M8, and the tenth thin film transistor M10 are still in off-state, and the fourth thin film transistor M4 and the sixth thin film transistor M6 are still in on-state, and the ninth thin film transistor M9 is still in off-state. Due to the second clock signal CK2, the fifth thin film transistor M5 and the seventh thin film transistor M7 are in off-state.

Thus, since the ninth thin film transistor M9 and the tenth thin film transistor M10 are both in off-state, the emission control signal EM keeps the low level being same as the low level in the third phase t3.

In summary, in the fourth phase t4, the emission control signal EM has a low level.

In the fifth phase t5, the initial signal EIN has a high level; the first clock signal CK1 has a high level, changed from the high level to a low level, and then changed from the low level to a high level; the second clock signal CK2 has a low level, changed from the low level to a high level, changed from the high level to a low level, and then changed from the low level to a high level.

When the first clock signal CK1 has the high level and the second clock signal CK2 has the low level, the first thin film transistor M1 and the third thin film transistor M3 are in off-state, and the fifth thin film transistor M5 and the seventh thin film transistor M7 are in on-state. Under the bootstrap effect of the first capacitor C1, the second node N2 is lowered and the voltage of the second node N2 is lower than the voltage of the second node N2 of the fourth stage t4, and then the fourth thin film transistor M4 and the sixth thin film transistor M6 are in on-state. Since the sixth thin film transistor M6 and the seventh thin film transistor M7 are both in on-state, the second clock signal CK2 may act on the third node N3 through the sixth thin film transistor M6 and the seventh thin film transistor M7, so that the third node N3 has the low level and then the ninth thin film transistor M9 is in on-state. Meanwhile, since the fourth thin film transistor M4 and the fifth thin film transistor M5 are on, the second power source VGH is applied to the first node N1 through the fourth thin film transistor M4 and the fifth thin film transistor M5, so that the first node N1 has the high level and then the second thin film transistor M2, the eighth thin film transistor M8, and the tenth thin film transistor M10 are in off-state.

Since the ninth thin film transistor M9 is in on-state and the tenth thin film transistor M10 is in off-state, the second power source VGH may be output by the ninth thin film transistor M9, so that the emission control signal EM has a high level.

When the second clock signal CK2 is changed from the low level to the high level and the first clock signal CK1 still has the high level, according to the description of the fourth stage t4 described above, the first node N1 still keeps the high level unchanged, the voltage of the third node N3 still keeps the low level unchanged. When the first clock signal CK1 is changed from the high level to the low level and the second clock signal CK2 still has the high level, based on the description of the fourth stage t4 described above, the first Node N1 still keeps the high level unchanged, and the third node N3 still keeps the low level unchanged. Similarly, when the first clock signal CK1 is changed from the low level to the high level, the second clock signal CK2 is changed from the high level to the low level, and then changed from the low level to the high level, the first node N1 still keeps the high level unchanged, and the third node N3 still keeps the low level unchanged.

In summary, in the fifth phase t5, when the first clock signal CK1 and the second clock signal CK2 are changed, the first node N1 will keep the high level unchanged, and the third node N3 will keep the low level unchanged. Therefore, the ninth thin film transistor M9 is in on-state, the tenth thin film transistor M10 is in off-state, the second power source VGH may be output by the ninth thin film transistor M9, so that the emission control signal EM has a high level.

In the sixth phase t6, the initial signal EIN has a low level, the first clock signal CK1 has a low level, and the second clock signal CK2 has a high level.

In the sixth phase t6, a working principle of the emission control circuit may be referred to a working principle of the emission control circuit in the first phase t1 described above, and a description of the working principle is not repeated herein.

In the sixth phase t6, the emission control signal EM has a low level.

In summary, in one duty period of the emission control circuit, a waveform diagram of the emission control signal EM which is output by the emission control unit may be as shown in FIG. 3.

The emission control circuit shown in FIG. 2 includes ten thin film transistors and three capacitors. Compared with the emission control circuit in the prior art, the number of thin film transistors and the number of capacitors are small, and the circuit structure of the emission control circuit is relatively simple.

### Second Embodiment

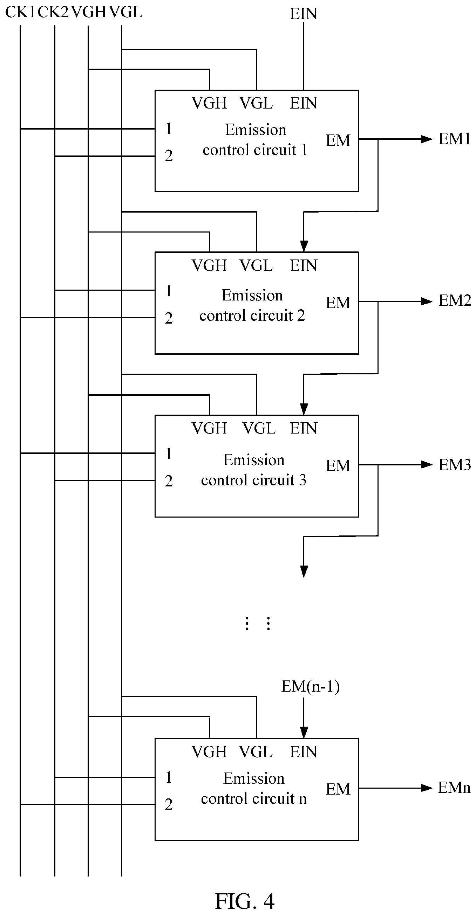

FIG. 4 is a schematic structural diagram of an emission control driver according to an embodiment of the present application. The emission control driver may include at least two stages emission control circuit described in the first Embodiment.

The emission control driver shown in FIG. 4 includes N stages of emission control circuits, which may include, respectively: an emission control circuit 1, an emission control circuit 2, an emission control circuit 3, ..., and an emission control circuit n. The emission control circuit 1 is a first stage emission control circuit, the emission control circuit 2 is a second stage emission control circuit, the emission control circuit 3 is a third stage emission control circuit, ..., and the emission control circuit n is a nth stage emission control circuit, n is an integer greater than 1.

In FIG. 4, an input signal of the emission control circuit 1 is an initial signal EIN, an emission control signal EM1 output by the emission control circuit 1 may be used as an initial signal of the emission control circuit 2, and the emission control signal output by the emission control circuit 2 may be used as an initial signal of the emission control circuit 3, ..., and so on, the emission control signal EM(n-1) output by the emission control circuit (n-1) may be used as an initial signal of the emission control circuit n, and n is the integer greater than 1.

A first clock signal of the emission control circuit 1 may be used as a second clock signal of the emission control circuit 2, and the second clock signal of the emission control circuit 1 may be used as a first clock signal of the emission control circuit 2; the first clock of the emission control circuit 2 may be used as a second clock signal of the emission control circuit 3, and the second clock signal of the emission control circuit 2 may be used as a first clock signal of the emission control circuit 3, ..., and so on, the first clock signal of the emission control circuit (n-1) may be used as a second clock signal of the emission control circuit n, and the second clock signal of the emission control circuit (n-1) may be used as a first clock signal of the emission control circuit n, and n is the integer greater than 1.

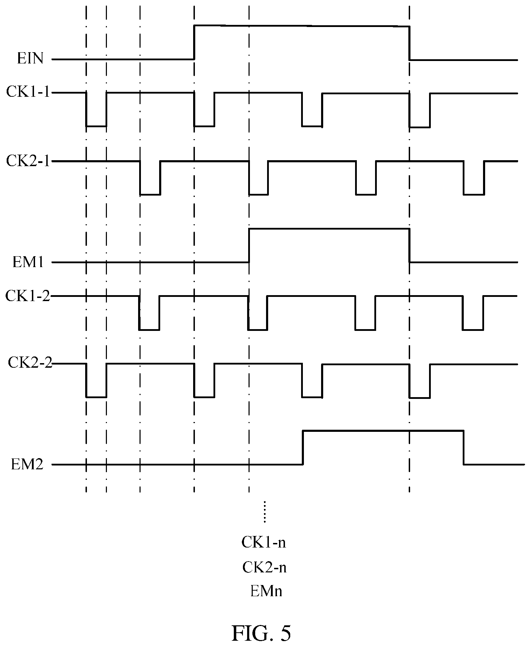

FIG. 5 is a timing diagram of the emission control driver according to an embodiment of the present application.

In FIG. 5, EIN is an initial signal input to a first stage of an emission control circuit, CK1-1 is a first clock signal input to the emission control circuit 1, and CK2-1 is a second clock signal input to the emission control circuit 1, and the emission control circuit 1 may output an emission control signal EM1 under control of the initial signal EIN, the first clock signal CK1-1, and the second clock signal CK2-1. The emission control signal EM1 may be used as an initial signal of an emission control circuit 2.

CK1-2 is a first clock signal input to the emission control circuit 2, CK2-2 is a second clock signal input to the emission control circuit 2, and the emission control circuit 2 may output an emission control signal EM2 under control of the initial signal EIN, the first clock signal CK1-2, and the second clock signal CK2-2. It can be seen from FIG. 5 that the first clock signal CK1-2 of the emission control circuit 2 is the same as the second clock signal CK2-1 of the emission control circuit 1, and the second clock signal CK2-2 of the emission control circuit 2 is the same as the first clock signal CK1-1 of the emission control circuit 1, and the emission control signal EM2 output from the emission control circuit 2 is delayed with respect to the emission control signal EM1 output from the emission control circuit 1.

As an analogy, an emission control signal EM(n-1) output by an emission control circuit (n-1) may be used as an initial signal of an emission control circuit n, and CK1-n is a first clock signal input to the emission control circuit n, CK2-n is a second clock signal input to the emission control circuit n. The first clock signal CK1-n may be the same as the second clock signal CK2-1, the second clock signal CK2-n may be the same as the first clock signal CK1-1, and the emission control circuit n may output the emission control signal EMn under control of the initial signal EM(n-1), the first clock signal CK1-n, and the second clock signal CK2-n. The initial signal EM(n-1), the first clock signal CK1-n, and the second clock signal CK2-n are not shown in FIG. 5.

### Third Embodiment

The embodiments of the present application further provide a display device, which may include an emission control driver as described above.

The appended claims are intended to be interpreted as including the preferred embodiments and all changes and modifications that fall within the scope of the present application.

## Claims

1. An emission control circuit, comprising a first control unit (11), a second control unit (12), and an emission control unit (13),
wherein:
the first control unit (11), of which an output terminal (N1) is configured to output a first control signal, is connected to an initial signal line (EIN), a first clock signal line (CK1) and a first power source (VGL), respectively;
the second control unit (12), of which an output terminal (N3) is configured to output a second control signal, is connected to the first control unit (11), a second clock signal line (CK2) and a second power source (VGH) respectively; and
the emission control unit (13), of which an output terminal is configured to output an emission control signal under control of the first control signal and the second control signal, is connected to the first control unit (11), the second control unit (12), the first power source (VGL) and the second power source (VGH) respectively;
wherein the emission control unit (13) comprises a ninth thin film transistor (M9), a tenth thin film transistor (M10), a second capacitor (C2), and a third capacitor (C3), and wherein:
a source of the ninth thin film transistor (M9) is connected to the second power source (VGH), a drain of the ninth thin film transistor (M9) is connected to a source of the tenth thin film transistor (M10), and a gate of the ninth thin film transistor (M9) is connected to the output terminal (N3), configured to output the second control signal, of the second control unit (12),
a drain of the tenth thin film transistor (M10) is connected to the first power source (VGL), and a gate of the tenth thin film transistor (M10) is connected to the output terminal (N1), configured to output the first control signal, of the first control unit (11),
a terminal of the second capacitor (C2) is connected to the output terminal of the second control unit (12) configured to output the second control signal, and another terminal of the second capacitor (C2) is connected to the second power source (VGH),
a terminal of the third capacitor (C3) is connected to the second clock signal line (CK2), and another terminal of the third capacitor (C3) is connected to the output terminal (N1), configured to output the first control signal, of the first control unit (11),
wherein the drain of the ninth thin film transistor (M9) and the source of the tenth thin film transistor (M10) are connected to the output terminal of the emission control unit (13), and a signal output by the drain of the ninth thin film transistor (M9) or the source of the tenth thin film transistor (M10) is the emission control signal;
wherein the first control unit (11) comprises a first thin film transistor (M1), a second thin film transistor (M2), and a third thin film transistor (M3), wherein:
a gate of the first thin film transistor (M1) is respectively connected to a source of the second thin film transistor (M2), a gate of the third thin film transistor (M3) and the first clock signal line (CK1),
a drain of the first thin film transistor (M1) is connected to the initial signal line (EIN), and a source of the first thin film transistor (M1) is connected to a gate of the second thin film transistor (M2),
a drain of the second thin film transistor (M2) is connected to a source of the third thin film transistor (M3),
a drain of the third thin film transistor (M3) is connected to the first power source (VGL), and
the source of the first thin film transistor (M1) is the output terminal of the first control unit (11), and a signal output by the output terminal of the first control unit (11) is the first control signal, wherein the second control unit (12) comprises a fourth thin film transistor (M4), a fifth thin film transistor (M5), a sixth thin film transistor (M6), a seventh thin film transistor (M7), an eighth thin film transistor (M8), and a first capacitor (C1), wherein:
a gate of the fourth thin film transistor (M4) is respectively connected to a gate of the sixth thin film transistor (M6) and a terminal of the first capacitor (CI), a source of the fourth thin film transistor (M4) is connected to a source of the fifth thin film transistor (M5), and a drain of the fourth thin film transistor (M4) is respectively connected to a drain of the eighth thin film transistor (M8) and the second power source (VGH),
a gate of the fifth thin film transistor (M5) is respectively connected to the second clock signal line (CK2), a drain of the sixth thin film transistor (M6), a gate of the seventh thin film transistor (M7) and another terminal of the first capacitor (C1), and a drain of the fifth thin film transistor (M5) is respectively connected to a gate of the eighth thin film transistor (M8) and a source of the first thin film transistor (M1),
a source of the sixth thin film transistor (M6) is connected to a source of the seventh thin film transistor (M7), and a drain of the seventh thin film transistor (M7) is connected to a source of the eighth thin film transistor (M8), and
the source of the eighth thin film transistor (M8) is the output terminal of the second control unit (12), and a signal output by the output terminal of the second control unit (12) is the second control signal.

2. The emission control circuit of claim 1, wherein the tenth thin film transistor (M10) is controlled by the first control signal to be in on-state or off-state, and the ninth thin film transistor (M9) is controlled by the second control signal to be in on-state or off-state.

3. The emission control circuit of claim 2,
wherein the ninth thin film transistor (M9) is controlled by the second control signal to be in off-state when the tenth thin film transistor (M10) is controlled by the first control signal to be in on-state; and
wherein the ninth thin film transistor (M9) is controlled by the second control signal to be in on-state when the tenth thin film transistor (M10) is controlled by the first control signal to be in off-state.

4. The emission control circuit of claim 3,
wherein, when the tenth thin film transistor (M9) is controlled by the first control signal to be in on-state and the ninth thin film transistor (M10) is controlled by the second control signal to be in off-state, the emission control signal is a voltage output by the first power source; and
wherein, when the tenth thin film transistor (M9) is controlled by the first control signal to be in off-state, and the ninth thin film transistor (M10) is controlled by the second control signal to be in on-state, the emission control signal is a voltage output by the second power source.

5. The emission control circuit according to any one of claims 1 to 4,
wherein the initial signal line (EIN) is configured to provide an initial signal, the first clock signal line (CK1) is configured to provide a first clock signal, and the second clock signal line (CK2) is configured to provide a second clock signal; and
wherein a voltage output by the first power source (VGL) is a negative voltage, and a voltage output by the second power source (VGH) is a positive voltage.

6. The emission control circuit of claim 1, wherein the first thin film transistor (M1), the second thin film transistor (M2), the third thin film transistor (M3), the fourth thin film transistor (M4), the fifth thin film transistor (M5), the sixth thin film transistor (M6), the seventh thin film transistor (M7), the eighth thin film transistor (M8), the ninth thin film transistor (M9) and the tenth thin film transistor (M10) are all P-type thin film transistors.

7. The emission control circuit of claim 1, wherein at least one of the first thin film transistor (M1), the second thin film transistor (M2), the third thin film transistor (M3), the fourth thin film transistor (M4), the fifth thin film transistor (M5), the sixth thin film transistor (M6), the seventh thin film transistor (M7), the eighth thin film transistor (M8), the ninth thin film transistor (M9), and the tenth thin film transistor (M10) is an N-type thin film transistor.

8. An emission control driver, **characterized in that** it comprises at least two stages of emission control circuits according to any one of claims 1 to 7,
wherein a signal input to a first stage emission control circuit is an initial signal, and an emission control signal output by a (n-1)th stage emission control circuit is used as an initial signal of a nth stage emission control circuit; and
wherein a first clock signal input to the (n-1)th stage emission control circuit is used as a second clock signal input to the nth stage emission control circuit, and a second clock signal input to the (n-1)th stage emission control circuit is used as a first clock signal input to the nth stage emission control circuit, and n is an integer greater than 1.

9. A display device, **characterized in that** it comprises the emission control driver according to claim 8.

## Patentansprüche

1. Emissionssteuerschaltung, die Folgendes umfasst: eine erste Steuereinheit (11), eine zweite Steuereinheit (12) und eine Emissionssteuereinheit (13),
wobei:
die erste Steuereinheit (11), bei der ein Ausgangsanschluss (N1) konfiguriert ist, um ein erstes Steuersignal auszugeben, jeweils mit einer Anfangssignalleitung (EIN), einer ersten Taktsignalleitung (CK1) und einer ersten Stromquelle (VGL) verbunden ist;
die zweite Steuereinheit (12), bei der ein Ausgangsanschluss (N3) konfiguriert ist, um ein zweites Steuersignal auszugeben, jeweils mit der ersten Steuereinheit (11), einer zweiten Taktsignalleitung (CK2) und einer zweiten Stromquelle (VGH) verbunden ist; und
die Emissionssteuereinheit (13), bei der ein Ausgangsanschluss konfiguriert ist, um ein Emissionssteuersignal unter Steuerung des ersten Steuersignals und des zweiten Steuersignals auszugeben, jeweils mit der ersten Steuereinheit (11), der zweiten Steuereinheit (12), der ersten Stromquelle (VGL) und der zweiten Stromquelle (VGH) verbunden ist;
wobei die Emissionssteuereinheit (13) einen neunten Dünnschichttransistor (M9), einen zehnten Dünnschichttransistor (M10), einen zweiten Kondensator (C2) und einen dritten Kondensator (C3) umfasst und wobei:
eine Quelle des neunten Dünnschichttransistors (M9) mit der zweiten Stromquelle (VGH) verbunden ist, ein Drain des neunten Dünnschichttransistors (M9) mit einer Quelle des zehnten Dünnschichttransistors (M10) verbunden ist, und ein Gate des neunten Dünnschichttransistors (M9) mit dem Ausgangsanschluss (N3) der zweiten Steuereinheit (12) verbunden ist, der konfiguriert ist, um das zweite Steuersignal auszugeben,
ein Drain des zehnten Dünnschichttransistors (M10) mit der ersten Stromquelle (VGL) verbunden ist, und ein Gate des zehnten Dünnschichttransistors (M10) mit dem Ausgangsanschluss (N1) der ersten Steuereinheit (11) verbunden ist, der konfiguriert ist, um das erste Steuersignal auszugeben, ein Anschluss des zweiten Kondensators (C2) mit dem Ausgangsanschluss der zweiten Steuereinheit (12) verbunden ist, der konfiguriert ist, um das zweite Steuersignal auszugeben, und ein anderer Anschluss des zweiten Kondensators (C2) mit der zweiten Stromquelle (VGH) verbunden ist,
ein Anschluss des dritten Kondensators (C3) mit der zweiten Taktsignalleitung (CK2) verbunden ist, und ein anderer Anschluss des dritten Kondensators (C3) mit dem Ausgangsanschluss (N1) der ersten Steuereinheit (11) verbunden ist, der konfiguriert ist, um das erste Steuersignal auszugeben, wobei der Drain des neunten Dünnschichttransistors (M9) und die Quelle des zehnten Dünnschichttransistors (M10) mit dem Ausgangsanschluss der Emissionssteuereinheit (13) verbunden ist, und es sich bei einem durch den Drain des neunten Dünnschichttransistors (M9) oder die Quelle des zehnten Dünnschichttransistors (M10) ausgegebenen Signal um das Emissionssteuersignal handelt;
wobei die erste Steuereinheit (11) einen ersten Dünnschichttransistor (M1), einen zweiten Dünnschichttransistor (M2) und einen dritten Dünnschichttransistor (M3) umfasst, wobei:
ein Gate des ersten Dünnschichttransistors (M1) jeweils mit einer Quelle des zweiten Dünnschichttransistors (M2), einem Gate des dritten Dünnschichttransistors (M3) und der ersten Taktsignalleitung (CK1) verbunden ist;
ein Drain des ersten Dünnschichttransistors (M1) mit der Anfangssignalleitung (EIN) verbunden ist, und eine Quelle des ersten Dünnschichttransistors (M1) mit einem Gate des zweiten Dünnschichttransistors (M2) verbunden ist,
ein Drain des zweiten Dünnschichttransistors (M2) mit einer Quelle des dritten Dünnschichttransistors (M3) verbunden ist,
ein Drain des dritten Dünnschichttransistors (M3) mit der ersten Stromquelle (VGL) verbunden ist, und
es sich bei der Quelle des ersten Dünnschichttransistors (M1) um den Ausgangsanschluss der ersten Steuereinheit (11) handelt und es sich bei einem von dem Ausgangsanschluss der ersten Steuereinheit (11) ausgegebenes Signal um das erste Steuersignal handelt;
wobei die zweite Steuereinheit (12) einen vierten Dünnschichttransistor (M4), einen fünften Dünnschichttransistor (M5), einen sechsten Dünnschichttransistor (M6), einen siebten Dünnschichttransistor (M7) und einen achten Dünnschichttransistor (M8) sowie einen ersten Kondensator (C1) umfasst, wobei:
ein Gate des vierten Dünnschichttransistors (M4) jeweils mit einem Gate des sechsten Dünnschichttransistors (M6) und einem Anschluss des ersten Kondensators (C1) verbunden ist, eine Quelle des vierten Dünnschichttransistors (M4) mit einer Quelle des fünften Dünnschichttransistors (M5) verbunden ist, und ein Drain des vierten Dünnschichttransistors (M4) jeweils mit einem Drain des achten Dünnschichttransistors (M8) und der zweiten Stromquelle (VGH) verbunden ist;
ein Gate des fünften Dünnschichttransistors (M5) jeweils mit der zweiten Taktsignalleitung (CK2), einem Drain des sechsten Dünnschichttransistors (M6), einem Gate des siebten Dünnschichttransistors (M7) und einem anderen Anschluss des ersten Kondensators (C1) verbunden ist, und ein Drain des fünften Dünnschichttransistors (M5) jeweils mit einem Gate des achten Dünnschichttransistors (M8) und einer Quelle des ersten Dünnschichttransistors (M1) verbunden ist;
eine Quelle des sechsten Dünnschichttransistors (M6) mit einer Quelle des siebten Dünnschichttransistors (M7) verbunden ist, und ein Drain des siebten Dünnschichttransistors (M7) mit einer Quelle des achten Dünnfilmtransistors (M8) verbunden ist; und es sich bei der Quelle des achten Dünnschichttransistors (M8) um den Ausgangsanschluss der zweiten Steuereinheit (12) handelt, und es sich bei einem von dem Ausgangsanschluss der zweiten Steuereinheit (12) ausgegebenes Signal um das zweite Steuersignal handelt.

2. Emissionssteuerschaltung nach Anspruch 1, wobei der zehnte Dünnschichttransistor (M10) durch das erste Steuersignal gesteuert wird, um sich im ein- oder ausgeschalteten Zustand zu befinden, und der neunte Dünnschichttransistor (M9) durch das zweite Steuersignal gesteuert wird, um sich im ein- oder ausgeschalteten Zustand zu befinden.

3. Emissionssteuerschaltung nach Anspruch 2,
wobei der neunte Dünnschichttransistor (M9) durch das zweite Steuersignal gesteuert wird, um sich im ausgeschalteten Zustand zu befinden, wenn der zehnte Dünnschichttransistor (M10) durch das erste Steuersignal gesteuert wird, um sich im eingeschalteten Zustand zu befinden; und
wobei der neunte Dünnschichttransistor (M9) durch das zweite Steuersignal gesteuert wird, um sich im eingeschalteten Zustand zu befinden, wenn der zehnte Dünnschichttransistor (M10) durch das erste Steuersignal gesteuert wird, um sich im ausgeschalteten Zustand zu befinden.

4. Emissionssteuerschaltung nach Anspruch 3,
wobei, wenn der zehnte Dünnschichttransistor (M10) durch das erste Steuersignal gesteuert wird, um sich im eingeschalteten Zustand zu befinden, und der neunte Dünnschichttransistor (M9) durch das zweite Steuersignal gesteuert wird, um sich im ausgeschalteten Zustand zu befinden, es sich bei dem Emissionssteuerungssignal um eine von der ersten Stromquelle ausgegebene Spannung handelt; und
wobei, wenn der zehnte Dünnschichttransistor (M10) durch das erste Steuersignal gesteuert wird, um sich im ausgeschalteten Zustand zu befinden, und der neunte Dünnschichttransistor (M9) durch das zweite Steuersignal gesteuert wird, um sich im eingeschalteten Zustand zu befinden, es sich bei dem Emissionssteuerungssignal um eine von der zweiten Stromquelle ausgegebene Spannung handelt.

5. Emissionssteuerschaltung nach einem der Ansprüche 1 bis 4,
wobei die Anfangssignalleitung (EIN) konfiguriert ist, um ein Anfangssignal bereitzustellen, die erste Taktsignalleitung (CK1) konfiguriert ist, um ein erstes Taktsignal bereitzustellen, und die zweite Taktsignalleitung (CK2) konfiguriert ist, um ein zweites Taktsignal bereitzustellen; und wobei es sich bei einer von der ersten Stromquelle (VGL) ausgegebenen Spannung um eine negative Spannung handelt, und es sich bei einer von der zweiten Stromquelle (VGH) ausgegebenen Spannung um eine positive Spannung handelt.

6. Emissionssteuerschaltung nach Anspruch 1, wobei es sich sowohl bei dem ersten Dünnschichttransistor (M1), als auch bei dem zweiten Dünnschichttransistor (M2), dem dritten Dünnschichttransistor (M3), dem vierten Dünnschichttransistor (M4), dem fünften Dünnschichttransistor (M5), dem sechsten Dünnschichttransistor (M6), dem siebten Dünnschichttransistor (M7), dem achten Dünnschichttransistor (M8), dem neunten Dünnschichttransistor (M9) und dem zehnten Dünnschichttransistor (M10) um Dünnschichttransistoren vom Typ P handelt.

7. Emissionssteuerschaltung nach Anspruch 1, wobei es sich bei wenigstens einem aus dem ersten Dünnschichttransistor (M1), dem zweiten Dünnschichttransistor (M2), dem dritten Dünnschichttransistor (M3), dem vierten Dünnschichttransistor (M4), dem fünften Dünnschichttransistor (M5), dem sechsten Dünnschichttransistor (M6), dem siebten Dünnschichttransistor (M7), dem achten Dünnschichttransistor (M8), dem neunten Dünnschichttransistor (M9) und dem zehnten Dünnschichttransistor (M10) um einen Dünnschichttransistor vom Typ N handelt.

8. Emissionssteuertreiber, der **dadurch gekennzeichnet ist, dass** er wenigstens zwei Stufen von Emissionssteuerschaltungen nach einem der Ansprüche 1 bis 7 umfasst,
wobei es sich bei einem Signal, das in eine Emissionssteuerschaltung der ersten Stufe eingegeben wird, um ein Anfangssignal handelt, und ein Emissionssteuersignal, das von einer Emissionssteuerschaltung der (n-1)-ten Stufe ausgegeben wird, als Anfangssignal einer Emissionssteuerschaltung der n-ten Stufe verwendet wird; und
eine erste Taktsignaleingabe in die Emissionssteuerschaltung der (n-1)-ten Stufe als zweite Taktsignaleingabe in die Emissionssteuerschaltung der n-ten Stufe verwendet wird, und eine zweite Taktsignaleingabe in die Emissionssteuerschaltung der (n-1)-ten Stufe als erste Taktsignaleingabe in die Emissionssteuerschaltung der n-ten Stufe verwendet wird, wobei n eine ganze Zahl größer als 1 ist.

9. Anzeigevorrichtung, die **dadurch gekennzeichnet ist, dass** sie den Emissionssteuertreiber nach Anspruch 8 umfasst.

## Revendications

1. Circuit de commande d'émission, comprenant: une première unité de commande (11), une deuxième unité de commande (12) et une unité de commande d'émission (13),
dans lequel :
la première unité de commande (11), dont une borne de sortie (N1) est conçue pour émettre un premier signal de commande, est respectivement reliée à une ligne de signal initial (EIN), à une première ligne de signal d'horloge (CK1) et à une première source d'alimentation (VGL) ;
la deuxième unité de commande (12), dont une borne de sortie (N3) est conçue pour émettre un deuxième signal de commande, est respectivement reliée à la première unité de commande (11), à une deuxième ligne de signal d'horloge (CK2) et à une deuxième source d'alimentation (VGH) ; et
l'unité de commande d'émission (13), dont une borne de sortie est conçue pour émettre un signal de commande d'émission sous la commande du premier signal de commande et du deuxième signal de commande, est respectivement reliée à la première unité de commande (11), à la deuxième unité de commande (12), à la première source d'alimentation (VGL) et à la deuxième source d'alimentation (VGH) ;
ladite unité de commande d'émission (13) comprenant un neuvième transistor à couches minces (M9), un dixième transistor à couches minces (M10), un deuxième condensateur (C2), et un troisième condensateur (C3), étant entendu que :
une source du neuvième transistor à couches minces (M9) est reliée à la deuxième source d'alimentation (VGH), un drain du neuvième transistor à couches minces (M9) est relié à une source du dixième transistor à couches minces (M10), et une grille du neuvième transistor à couches minces (M9) est reliée à la borne de sortie (N3), conçue pour émettre le deuxième signal de commande, de la deuxième unité de commande (12),
un drain du dixième transistor à couches minces (M10) est relié à la première source d'alimentation (VGL), et une grille du dixième transistor à couches minces (M10) est reliée à la borne de sortie (N1), conçue pour émettre le premier signal de commande, de la première unité de commande (11),
une borne du deuxième condensateur (C2) est reliée à la borne de sortie de la deuxième unité de commande (12) conçue pour émettre le deuxième signal de commande, et une autre borne du deuxième condensateur (C2) est reliée à la deuxième source d'alimentation (VGH),
une borne du troisième condensateur (C3) est reliée à la deuxième ligne de signal d'horloge (CK2), et une autre borne du troisième condensateur (C3) est reliée à la borne de sortie (N1), conçue pour émettre le premier signal de commande, de la première unité de commande (11),
ledit drain du neuvième transistor à couches minces (M9) et la source du dixième transistor à couches minces (M10) étant reliés à la borne de sortie de l'unité de commande d'émission (13), et un signal émis par le drain du neuvième transistor à couches minces (M9) ou la source du dixième transistor à couches minces (M10) est le signal de commande d'émission ;
ladite première unité de commande (11) comprenant un premier transistor à couches minces (M1), un deuxième transistor à couches minces (M2) et un troisième transistor à couches minces (M3), étant entendu que :
une grille du premier transistor à couches minces (M1) est respectivement reliée à une source du deuxième transistor à couches minces (M2), à une grille du troisième transistor à couches minces (M3) et à la première ligne de signal d'horloge (CK1),
un drain du premier transistor à couches minces (M1) est relié à la ligne de signal initial (EIN), et
une source du premier transistor à couches minces (M1) est reliée à une grille du deuxième transistor à couches minces (M2),
un drain du deuxième transistor à couches minces (M2) est relié à une source du troisième transistor à couches minces (M3),
un drain du troisième transistor à couches minces (M3) est relié à la première source d'alimentation (VGL), et
la source du premier transistor à couches minces (M1) est la borne de sortie de la première unité de commande (11), et un signal émis par la borne de sortie de la première unité de commande (11) est le premier signal de commande ;
ladite deuxième unité de commande (12) comprenant un quatrième transistor à couches minces (M4), un cinquième transistor à couches minces (M5), un sixième transistor à couches minces (M6), un septième transistor à couches minces (M7), un huitième transistor à couches minces (M8) et un premier condensateur (C1), étant entendu que :
une grille du quatrième transistor à couches minces (M4) est respectivement reliée à une grille du sixième transistor à couches minces (M6) et à une borne du premier condensateur (C1), une source du quatrième transistor à couches minces (M4) est reliée à une source du cinquième transistor à couches minces (M5), et un drain du quatrième transistor à couches minces (M4) est respectivement relié à un drain du huitième transistor à couches minces (M8) et à la deuxième source d'alimentation (VGH) ;
une grille du cinquième transistor à couches minces (M5) est respectivement reliée à la deuxième ligne de signal d'horloge (CK2), à un drain du sixième transistor à couches minces (M6), à une grille du septième transistor à couches minces (M7) et à une autre borne du premier condensateur (C1), et un drain du cinquième transistor à couches minces (M5) est respectivement relié à une grille du huitième transistor à couches minces (M8) et à une source du premier transistor à couches minces (M1) ;
une source du sixième transistor à couches minces (M6) est reliée à une source du septième transistor à couches minces (M7), et un drain du septième transistor à couches minces (M7) est relié à une source du huitième transistor à couches minces (M8) ; et
la source du huitième transistor à couches minces (M8) est la borne de sortie de la deuxième unité de commande (12), et un signal émis par la borne de sortie de la deuxième unité de commande (12) est le deuxième signal de commande.

2. Circuit de commande d'émission selon la revendication 1, dans lequel le dixième transistor à couches minces (M10) est commandé par le premier signal de commande de façon à être activé ou désactivé, et le neuvième transistor à couches minces (M9) est commandé par le deuxième signal de commande de façon à être activé ou désactivé.

3. Circuit de commande d'émission selon la revendication 2,
dans lequel le neuvième transistor à couches minces (M9) est commandé par le deuxième signal de commande de façon à être désactivé lorsque le dixième transistor à couches minces (M10) est commandé par le premier signal de commande de façon à être activé ; et
dans lequel le neuvième transistor à couches minces (M9) est commandé par le deuxième signal de commande de façon à être activé lorsque le dixième transistor à couches minces (M10) est commandé par le premier signal de commande de façon à être désactivé.

4. Circuit de commande d'émission selon la revendication 3,
dans lequel, lorsque le dixième transistor à couches minces (M10) est commandé par le premier signal de commande de façon à être activé et le neuvième transistor à couches minces (M9) est commandé par le deuxième signal de commande de façon à être désactivé, le signal de commande d'émission est une tension émise par la première source d'alimentation ; et
dans lequel, lorsque le dixième transistor à couches minces (M10) est commandé par le premier signal de commande de façon à être désactivé, et le neuvième transistor à couches minces (M9) est commandé par le deuxième signal de commande de façon à être activé, le signal de commande d'émission est une tension émise par la deuxième source d'alimentation.

5. Circuit de commande d'émission selon l'une quelconque des revendications 1 à 4,
dans lequel la ligne de signal initial (EIN) est conçue pour fournir un signal initial, la première ligne de signal d'horloge (CK1) est conçue pour fournir un premier signal d'horloge, et la deuxième ligne de signal d'horloge (CK2) est conçue pour fournir un deuxième signal d'horloge ; et
dans lequel la tension émise par la première source d'alimentation (VGL) est une tension négative, et la tension émise par la deuxième source d'alimentation (VGH) est une tension positive.

6. Circuit de commande d'émission selon la revendication 1, dans lequel les premier transistor à couches minces (M1), deuxième transistor à couches minces (M2), troisième transistor à couches minces (M3), quatrième transistor à couches minces (M4), cinquième transistor à couches minces (M5), sixième transistor à couches minces (M6), septième transistor à couches minces (M7), huitième transistor à couches minces (M8), neuvième transistor à couches minces (M9) et dixième transistor à couches minces (M10) sont tous des transistors à couches minces de type P.

7. Circuit de commande d'émission selon la revendication 1, dans lequel au moins un des premier transistor à couches minces (M1), deuxième transistor à couches minces (M2), troisième transistor à couches minces (M3), quatrième transistor à couches minces (M4), cinquième transistor à couches minces (M5), sixième transistor à couches minces (M6), septième transistor à couches minces (M7), huitième transistor à couches minces (M8), neuvième transistor à couches minces (M9) et dixième transistor à couches minces (M10) est un transistor à couches minces de type N.

8. Pilote de commande d'émission, **caractérisé en ce qu'**il comprend au moins deux étages de circuits de commande d'émission selon l'une quelconque des revendications 1 à 7,
dans lequel un signal introduit dans un circuit de commande d'émission de premier étage est un signal initial, et un signal de commande d'émission émis par un circuit de commande d'émission de (n-1)-ième étage sert de signal initial d'un circuit de commande d'émission de n-ième étage ; et un premier signal d'horloge introduit dans le circuit de commande d'émission de (n-1)-ième étage sert de deuxième signal d'horloge introduit dans le circuit de commande d'émission de n-ième étage, et un deuxième signal d'horloge introduit dans le circuit de commande d'émission de (n-1)-ième étage sert de premier signal d'horloge introduit dans le circuit de commande d'émission de n-ième étage, et n est un nombre entier supérieur à 1.

9. Dispositif d'affichage, **caractérisé en ce qu'**il comprend le pilote de commande d'émission selon la revendication 8.
